(19) Europäisches Patentamt / European Patent Office / Office européen des brevets

(11) **EP 2 756 518 B1**

(12) **FASCICULE DE BREVET EUROPEEN**

(45) Date de publication et mention de la délivrance du brevet:
**11.01.2017 Bulletin 2017/02**

(21) Numéro de dépôt: **12756503.4**

(22) Date de dépôt: **12.09.2012**

(51) Int Cl.:
*H01J 37/317* *(2006.01)*

(86) Numéro de dépôt international:
**PCT/EP2012/067756**

(87) Numéro de publication internationale:
**WO 2013/037788 (21.03.2013 Gazette 2013/12)**

(54) **PROCÉDÉ DE CORRECTION DES EFFETS DE PROXIMITÉ ÉLECTRONIQUE UTILISANT UNE DÉCONVOLUTION DU MOTIF À INSOLER PAR UNE MÉTHODE PROBABILISTE**

PROZESS ZUR KORREKTUR VON ELEKTRONISCHEN NAHWIRKUNGSEFFEKTEN UNTER VERWENDUNG EINER ENTFALTUNG DES ZU ERZEUGENDEN MUSTERS MIT EINEM PROBABILISTISCHEN VERFAHREN

ELECTRONIC PROXIMITY EFFECT CORRECTION PROCESS USING A DECONVOLUTION OF THE TO-BE-PRINTED PATTERN BY A PROBABILISTIC METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.09.2011 FR 1158123**
**13.09.2011 FR 1158130**

(43) Date de publication de la demande:
**23.07.2014 Bulletin 2014/30**

(73) Titulaires:
• **Commissariat à l'Énergie Atomique et aux Énergies Alternatives**
**75015 Paris (FR)**
• **Aselta Nanographics**
**38000 Grenoble (FR)**

(72) Inventeur: **SOULAN, Sébastien**
**F-38610 Gieres (FR)**

(74) Mandataire: **Nguyen Van Yen, Christian**
**Marks & Clerk France**
**Conseils en Propriété Industrielle**
**Immeuble Visium**
**22, Avenue Aristide Briand**
**94117 Arcueil Cedex (FR)**

• **MANAKLI ET AL: "Cell projection use in maskless lithography for 45 nm and 32 nm logic nodes", PROCEEDINGS OF SPIE: ALTERNATIVE LITHOGRAPHIC TECHNOLOGIES, vol. 7271, 24 février 2009 (2009-02-24), pages 72710K-1-72710K-9, XP040495581,**
• **MARTIN ET AL: "Multiple pass exposure in e-beam lithography: application to the sub-22nm nodes", PROCEEDINGS OF SPIE: ALTERNATIVE LITHOGRAPHIC TECHNOLOGIES II , vol. 7637 23 février 2010 (2010-02-23), pages 76370E-1-76370E-10, XP002680697, Extrait de l'Internet: URL:http://spiedigitallibrary.org/proceedi ngs/resource/2/psisdg/7637/1/76370E_1 [extrait le 2012-07-23]**
• **"Transform based proximity corrections : Experimental results and comparisons" In: M.E. HASLAM; J.F. MCDONALD: "J. Vac. Sci. Technol.", janvier 1986 (1986-01), CENTER FOR INTEGRATED ELECTRONICS, RENSSELAER POLYTECHNIC INSTITUTE, XP002680208, vol. B4 cité dans la demande abrégé; figures 4,5,7,13 le document en entier**

(56) Documents cités:
**US-A1- 2008 067 446    US-A1- 2008 116 398**

- EISENMANN H ET AL: "PROXECCO--Proximity effect correction by convolution", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 11, no. 6, 1 novembre 1993 (1993-11-01), pages 2741-2745, XP002612755, ISSN: 0734-211X, DOI: 10.1116/1.586594
- MARTIN L ET AL: "New writing strategy in electron beam direct write lithography to improve critical dense lines patterning for sub-45nm nodes", PROCEEDINGS OF SPIE, SPIE, US, vol. 7470, 12 janvier 2009 (2009-01-12), pages 1-12, XP002657640, ISSN: 0277-786X, DOI: 10.1117/12.835189 [extrait le 2009-06-12] cité dans la demande
- MANAKLI S ET AL: "Complementary dose and geometrical solutions for electron beam direct write lithography proximity effects correction: Application for sub- 45-nm node product manufacturing", JOURNAL OF MICRO/NANOLITHOGRAPHY, MEMS, AND MOEMS, SPIE - INTERNATIONAL SOCIETY FOR OPTICAL ENGINEERING, US, vol. 6, no. 3, 1 décembre 2007 (2007-12-01), pages 33001-1, XP002633889, ISSN: 1932-5150, DOI: 10.1117/1.2770472 [extrait le 2007-08-13]
- RICHARDSON W H: "Bayesian-based iterative method of image restoration", JOURNAL OF THE OPTICAL SOCIETY OF AMERICA, AMERICAN INSTITUTE OF PHYSICS, NEW YORK; US, vol. 62, no. 1, 1 janvier 1972 (1972-01-01), pages 55-59, XP002513976, ISSN: 0093-5433, DOI: 10.1364/JOSA.62.000055

## Description

La présente invention s'applique notamment au domaine de la lithographie électronique pour la gravure directe sur wafer ou pour la fabrication de masques. Aux dimensions critiques inférieures à 22 nm atteintes par les technologies en production, l'interaction du faisceau d'électrons avec la cible est notamment affectée par une diffusion des électrons autour de la trajectoire initiale (effet de forward scattering ou de diffusion vers l'avant) ainsi que par une rétrodiffusion (effet de back scattering ou de diffusion vers l'arrière). Ces effets, qualifiés d'effets de proximité, dépendent notamment des matériaux de la cible et de sa géométrie. Il est donc nécessaire de tenir compte des effets de proximité pour obtenir des motifs gravés fidèles au design défini. Pour cela, il est connu d'appliquer deux méthodes, en général de manière indépendante. D'une part, on modélise les effets de proximité pour moduler les doses de rayonnement électronique utilisées pour bombarder la cible. D'autre part, on modifie le design source en fonction de règles de dessin élaborées de manière plus ou moins empirique pour que le design cible soit conforme à l'objectif recherché.

En ce qui concerne la modulation de dose, l'état de l'art de référence est constitué par la publication de Eisenmann (« Proxecco - Proximity Effect Correction by Convolution » - H. Eisenmann, T. Waas, H. Hartmann - J. Vac. Sci. Technol., vol B11, N °6, pp 2741-2745, Nov-Dec. 1993) et le logiciel commercialisé sous la marque Proxecco™. La modulation de dose est appliquée à un motif fracturé, chaque élément de base recevant une dose modulée qui est générée à partir d'un modèle des effets de proximité. Ledit modèle utilise généralement une fonction dite de diffusion ou d'étalement de point (ou PSF, point spread function). La PSF de Eisenmann est une paire de gaussiennes, l'une pour la diffusion vers l'avant et l'autre pour la diffusion vers l'arrière. Les doses locales sont déterminées par convolution de la PSF avec la géométrie de la cible.

Celle-ci est le cas échéant corrigée selon un principe analogue à ceux de l'Optical Proximity Correction (OPC) utilisée en lithographie optique. La correction géométrique à appliquer est en général déterminée par une optimisation automatique des dimensions des formes : une ligne sera par exemple amincie, épaissie, allongée ou rétrécie. Un dessinateur peut également proposer des géométries alternatives qui lui sont suggérées par son savoir-faire. Les corrections ainsi déterminées pour un type de motif permettent de générer des règles de correction qui sont ensuite appliquées automatiquement sur tous les points de la puce qui ont la même configuration. Pour un exposé détaillé des différentes modalités de correction géométrique on pourra se reporter notamment aux publications de Sewell et de Cook (« Control of Pattern Dimensions in Electron Lithography » - H. Sewell, J. Vac. Sci. Technol., 15, 927 (1978) ; « Dose, Shape and Hybrid Modifications for PYRAMID in Electron Beam Proximity Effect Correction » - Brian D. Cook, Soo Young Lee - IEEE transactions on semiconductor manufacturing, vol. 11, N°1, Feb. 1998).

Il est également connu de décomposer l'exposition en plusieurs passes. L'étape d'exposition supplémentaire s'applique alors en général à des géométries plus fines afin notamment d'améliorer la résolution et la fenêtre de procédé. On parle alors d'étape de procédé ou de fonction eRIF (electron Resolution Improvement Feature). Des procédés de ce type ont été décrits notamment par Martin et Manakli (« New writing strategy in electron beam direct write lithography to improve critical dense fines patterning for sub-45nm nodes » - L. Martin - EMLC 2009 ; demande internationale de brevet n° PCT/EP2011/055746 ayant pour titre «Procédé de lithographie électronique avec correction des arrondissements de coins », dont S. Manakli est inventeur et dont le titulaire est un des co-déposants de la présente demande de brevet.

Le calcul séparé des paramètres de ces différents procédés conduit cependant à une solution sous-optimale à la fois en temps de conception et en temps d'exposition. Des solutions de calcul conjoint des paramètres de modulation de dose et de correction géométrique ont déjà été proposées. Une voie est celle proposée par la demande internationale de brevet n° PCT/EP2011/055863 ayant pour titre «Procédé de lithographie à optimisation combinée de l'énergie rayonnée et de la géométrie de dessin », dont S. Manakli est inventeur et dont le titulaire est un des co-déposants de la présente demande de brevet. Selon ce procédé, l'énergie rayonnée dans une dose appliquée à une zone et les dimensions du motif à graver sur cette zone sont calculées en combinaison par l'intermédiaire de la latitude en énergie du procédé. Ce procédé marche bien pour des motifs simples tels que des cellules à grande maille, des fins de lignes et des coins, notamment. Il est moins efficace pour des motifs plus complexes. Une autre voie d'optimisation conjointe des paramètres de dose rayonnée et de géométrie projetée consiste à minimiser l'écart entre le résultat de la convolution d'une dose rayonnée avec la PSF et le motif cible. Pour ce faire, il a été suggéré de déconvoluer le motif à graver par une méthode appropriée. L'utilisation de transformées de Fourier inverses en combinaison avec une PSF classique à deux gaussiennes telle que proposée par Eisenmann (référence citée ci-dessus) a été préconisée par Haslam (« Transform based proximity corrections : Expérimental results and comparisons » - M.E. Haslam, J.F. McDonald, Center for Integrated Electronics, Rensselaer Polytechnic Institute, Troy, New-York - J. Vac. Sci. Technol. B4(1), Janv/Feb 1986). Cependant, aux dimensions pertinentes pour les technologies actuellement en production ou en développement (dimension critique de une à deux dizaines de nanomètres), cette méthode n'est plus adaptée en raison de la coupure qu'elle réalise des hautes fréquences spatiales, inhérente à la l'inversion, qui empêche une prise en compte suffisamment précise des effets de diffusion vers l'avant qui dominent à ces distances.

L'invention résout ce problème en proposant de combiner une PSF d'un type particulier avec une déconvolution du motif à graver utilisant une méthode itérative de type probabiliste.

Avantageusement, l'invention peut être mise en oeuvre dans le cadre d'un procédé de lithographie par projection de cellules qui autorise une plus grande rapidité d'exposition. Dans ce but, on combine le procédé de correction des effets de proximité par la méthode itérative probabiliste de l'invention avec un procédé de projection de cellules à plusieurs niveaux d'exposition qui permet une correction fine des effets de proximité.

A cet effet, l'invention prévoit un procédé de lithographie par rayonnement , selon la revendication 1, d'au moins un motif à insoler sur un support résiné comprenant au moins une étape de génération d'une fonction choisie d'étalement de point dudit rayonnement et une étape d'application d'une méthode choisie de déconvolution audit motif à insoler par ladite fonction d'étalement de point , ledit procédé étant caractérisé en ce que ladite fonction d'étalement de point est choisie pour ne modéliser que les effets de diffusion dudit rayonnement vers l'avant et en ce que ladite méthode de déconvolution est choisie parmi les méthodes modélisant les interactions dudit rayonnement avec le support résiné par une distribution de probabilité conjointe des dites interactions.

Avantageusement, ladite méthode de déconvolution comprend une étape de calcul d'un maximum de vraisemblance de chaque point source dudit rayonnement pour tous les points image du motif à insoler, chaque point image étant multiplié par la valeur de la fonction d'étalement de point entre le point source et le point image.

Avantageusement, ladite méthode de déconvolution est une méthode de Lucy-Richardson.

Avantageusement, le procédé de lithographie de l'invention comprend en outre une étape de tramage de l'image déconvoluée du motif à insoler.

Avantageusement, le procédé de lithographie de l'invention comprend en outre une étape de découpage de l'image déconvoluée en au moins deux niveaux distincts d'exposition.

Avantageusement, les au moins deux niveaux distincts d'exposition sont choisis pour maximiser la population en pixels de chacun des niveaux.

Avantageusement, le procédé de lithographie de l'invention comprend en outre une étape de vectorisation de l'image déconvoluée du motif à insoler. Avantageusement, la fonction d'étalement de point est une gaussienne. Avantageusement, la largeur à mi-hauteur de la gaussienne est comprise entre 3nm et 15nm.

L'invention prévoit également un programme d'ordinateur, selon la revendication 10, comprenant des instructions de code de programme mettant en oeuvre le procédé de lithographie par rayonnement de l'invention lorsque le programme est exécuté sur un ordinateur, ledit programme comprenant une fonction de génération d'une fonction choisie d'étalement de point dudit rayonnement et un module d'application d'une méthode choisie de déconvolution aux sorties éventuellement filtrées de ladite fonction d'étalement des points dudit rayonnement appliquée audit motif à insoler, ledit programme étant caractérisé en ce que ladite fonction d'étalement de point est choisie pour ne modéliser que les effets de diffusion dudit rayonnement vers l'avant et en ce que ladite méthode de déconvolution est choisie parmi les méthodes modélisant les interactions des points dudit rayonnement par une distribution de probabilité conjointe des dites interactions.

Avantageusement, le programme d'ordinateur de l'invention comprend en outre une fenêtre d'interface dans laquelle un opérateur peut programmer l'application à au moins un deuxième motif appartenant à une classe déterminée de règles de correction déterminées par déconvolution d'un premier motif appartenant à ladite classe.

L'invention est particulièrement avantageuse car elle permet de parvenir de manière complètement automatique à une image rayonnée optimale. Les limitations du procédé ne dépendent plus que des limitations de la machine de lithographie et des arbitrages à effectuer pour favoriser le rendement global du procédé. Ce niveau de résultat n'aurait été accessible auparavant, pour les types de motifs complexes qui peuvent être ainsi traités, qu'au prix d'une modulation de dose de très grande précision et de corrections géométriques très sophistiquées nécessitant une longue mise au point.

En outre, le procédé de l'invention génère une image déconvoluée en niveaux de gris qui pourra subir des traitements différents selon que l'on utilise une machine d'exposition à matrice de points ou une machine de projection à faisceau formé (de type Variable Shaped Beam ou VSB).

Dans ce deuxième cas, il est d'ailleurs possible de générer automatiquement des eRIF qui permettront d'améliorer la résolution et la vitesse d'écriture, ce qui constitue un avantage supplémentaire.

D'autre part, avec un procédé de projection de cellules multi-passes utilisable avec le procédé de l'invention, on peut générer automatiquement plusieurs groupes d'ouvertures sur un stencil (ou groupe de cellules caractères) en sortie d'une étape de déconvolution du motif à insoler ayant généré la solution optimale aux plans de la modulation de dose et du design source, chaque groupe d'ouvertures correspondant à un niveau d'exposition. La modulation de dose s'effectuera alors sur autant de paramètres que de niveaux et sera réalisée à l'intérieur d'une cellule. Ainsi, la projection de cellules utilisable avec le procédé de l'invention permet de réaliser l'insolation de motifs plus complexes que les procédés de l'art antérieur, et avec des dimensions critiques inférieures.

L'invention sera mieux comprise, ses différentes caractéristiques et avantages ressortiront de la description qui suit de plusieurs exemples de réalisation et de ses figures annexées dont :

- La figure 1 illustre l'application de doses modulées selon l'art antérieur;
- La figure 2 représente un organigramme des traitements à appliquer pour mettre en oeuvre l'invention dans plusieurs de ses modes de réalisation ;
- Les figures 3a et 3b représentent respectivement un motif à exposer et sa PSF associée, selon un mode de réalisation de l'invention ;
- Les figures 4a et 4b représentent respectivement une image en niveaux de gris d'un motif à exposer et sa transformée en image binaire par tramage, selon un mode de réalisation de l'invention ;
- Les figures 5a et 5b représentent respectivement une image en mode bitmap d'un motif à exposer et sa transformée en image vectorielle, selon un mode de réalisation de l'invention ;
- Les figures 6a, 6b et 6c représentent trois niveaux d'exposition différents, selon un mode de réalisation de l'invention ;
- La figure 7 illustre un stencil comportant différentes ouvertures pour réaliser une ou plusieurs insolations dans un mode de réalisation utilisant une projection de cellule;
- Les figures 8b et 8a représentent respectivement une cellule caractère d'un stencil de l'art antérieur et les cellules du design que l'on cherche à insoler par un procédé à projection de cellules correspondant à cette cellule caractère;
- Les figures 9a et 9b représentent respectivement les deux cellules caractères déterminées pour exposer le motif source de la figure 8b;
- Les figures 10a et 10b représentent respectivement la cellule du design obtenue après insolation au travers de la cellule caractère de la figure 8b et celle obtenue après insolation au travers des deux cellules caractères des figures 9a et 9b;
- Les figures 11a, 11b et 11c représentent respectivement trois niveaux d'exposition différents réalisés avec trois cellules caractères.

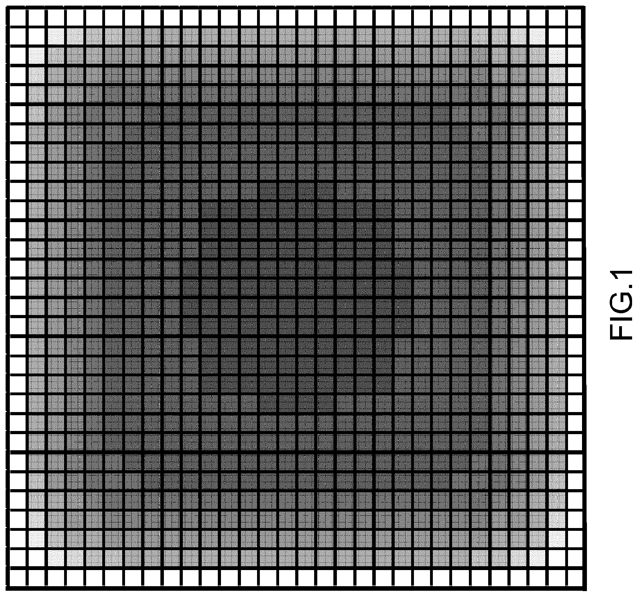

La figure 1 illustre l'application de doses modulées selon l'art antérieur.

On constate que l'exposition est corrigée en fonction de la position des motifs. Les doses reçues sont plus élevées en bordure de plaquette qu'au centre. En effet, les motifs situés à l'intérieur reçoivent en proportion des électrons rétrodiffusés en provenance des zones contiguës plus nombreux que les zones situées en bordure..

Selon Eisenmann (référence citée ci-dessus), ces modulations de doses sont calculées à partir de la PSF f(x, y) à double gaussienne suivante :

$$f(\xi) = \frac{1}{\pi(1+\eta)} \left( \frac{1}{\alpha^2} e^{\frac{-\xi^2}{\alpha^2}} + \frac{\eta}{\beta^2} e^{\frac{-\xi^2}{\beta^2}} \right)$$

Avec les notations :

○ $\alpha$ est la largeur du rayonnement direct;
○ $\beta$ est la largeur de rétrodiffusion ;
○ $\eta$ est le ratio des intensités des rayonnements direct et rétrodiffusé.
○ $\xi$ est la position radiale d'un point (x, y).

Les valeurs des paramètres $\alpha$, $\beta$ et $\eta$ peuvent être déterminées expérimentalement pour un procédé donné. Ces paramètres sont fonction de la tension d'accélération de la machine et de la cible.

Selon Eisenmann, pour effectuer la correction illustrée par la figure 1, il suffit de traiter le phénomène à rayon d'action élevé (supérieur au micron) par rapport aux points d'impact, soit l'effet de diffusion vers l'arrière, et on peut ne pas tenir compte des effets de diffusion vers l'avant qui sont dominants à faible distance (rayon d'action d'un ordre de grandeur plus faible pour les basses tensions d'accélération (de l'ordre de 5kV) et deux ordres de grandeur pour les accélérations plus fortes (typiquement 50kV)). Il est possible d'effectuer une déconvolution de l'effet de la PSF par une transformée de Fourier inverse:

$$p = F^{-1} \left( \frac{F(r)}{F(PSF)} \right)$$

Il est nécessaire de réaliser une troncature des fréquences spatiales élevées pour éviter l'annulation du dénominateur. Ces fréquences étant représentatives de la diffusion vers l'avant, cela n'est pas gênant dans l'application décrite par Eisenmann.

L'image résultante *r* est reconstituée comme la somme d'un terme égal à cette déconvolution tronquée des hautes fréquences et d'un terme proportionnel à l'image source *p* :

$$r = F^{-1} \left[ g_{conv} \times F(p) \right] + C \times p$$

Ainsi la partie du motif proche du centre du faisceau est-elle bien réintroduite dans l'image résultante, mais sans correction.

Cette méthode de déconvolution n'est pas applicable lorsque l'on s'intéresse précisément aux fréquences spatiales élevées, ce qui est le cas de la présente invention. L'invention propose une méthode permettant de surmonter cette limitation.

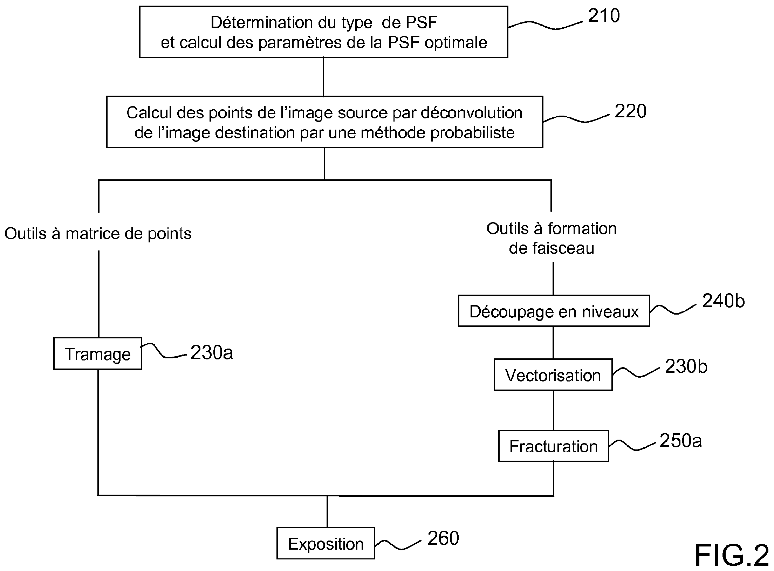

La figure 2 représente un organigramme des traitements à appliquer pour mettre en oeuvre l'invention dans plusieurs de ses modes de réalisation.

Les premières étapes 210, 220 du procédé de l'invention sont indépendantes de l'outil d'exposition utilisé. Il s'agit d'abord de choisir le type de PSF utilisé. Puisque l'on s'intéresse essentiellement aux phénomènes dominants à une échelle de l'ordre de la dizaine de nanomètres, il n'est pas nécessaire de modéliser dans la PSF l'effet de diffusion vers l'arrière. On choisira donc en règle générale au cours de l'étape 210 une PSF qui ne modélise que l'effet de diffusion vers l'avant, qui génère l'essentiel des effets de proximité à l'échelle à laquelle on se situe. Avantageusement, on choisira pour la PSF une gaussienne dont la largeur à mi-hauteur sera comprise entre 3 nm et 15nm. D'autres fonctions peuvent néanmoins convenir, notamment des fonctions symétriques de largeur à la base comprise typiquement entre 10nm et 50 nm.

Une fois le type de PSF choisi, il s'agit d'appliquer au cours d'une étape 220 une méthode de déconvolution adaptée. Ladite méthode doit à la fois être adaptée à la fonction à déconvoluer, être convergente et réaliser cette convergence dans un temps admissible.

Dans le cadre de la présente invention, on se propose d'utiliser des méthodes appartenant à la classe des méthodes probabilistes de déconvolution. Les méthodes de ce type utilisant des itérations sur une variable aléatoire conditionnelle semblent les plus adaptées. En effet, par l'effet de diffusion, la dose reçue en un point dépendra des doses rayonnées en tous les points voisins. Il s'agit donc de calculer en tout point $j$ la dose $p_j$ à générer telle qu'en un point $i$ la dose reçue effective soit $r_i$, étant entendu que la dose $p_j$ rayonnera en d'autres points que $i$ selon une distribution donnée par la PSF que l'on peut discrétiser en un ensemble de valeurs $u_{i,i}$. Il convient donc de résoudre le problème :

$$r_i = \sum_j u_{i,j} p_j$$

Une des méthodes testées, dont la convergence a été confirmée, est l'algorithme de Lucy-Richardson (« Bayesian-Based Iterative Method of Image Restoration » - W. Hadley-Richardson, Visibility Laboratory, University of California at San Diego - Journal of the Optical Society of America, Vol. 62, N°1, Jan. 1972).

On suppose que $p_j$ suit une loi donnée (par exemple une loi de Poisson), et on recherche pour tout $j$ la valeur la plus probable pour un $r_i$ connaissant par ailleurs $u_{i,j}$.

Cela revient à résoudre l'équation récursive suivante :

$$p_j^{(t+1)} = p_j^{(t)} \sum_i \frac{r_i}{c_i} u_{i,j}$$

$$\text{Avec } c_i = \sum_j p_{i,j} u_j^{(t)}$$

L'algorithme converge donc, bien que lentement. D'autres méthodes de la même famille, notamment celles dites « EM », pour Expectation - Maximization, basées sur une alternance d'étapes de calcul d'espérance mathématique et de maxima de vraisemblance, pourront être utilisées sans sortir du cadre de l'invention.

L'image déconvoluée est obtenue en niveaux de gris, chaque niveau en chaque point codant l'intensité de la dose à rayonner. Une opération unique permet donc de réaliser à la fois la modulation de dose et la correction géométrique toutes deux optimales pour le motif à exposer. Cette opération unique s'intègre donc en lieu et place de ces deux opérations dans les procédés de l'art antérieur de préparation des données (dataprep) implantés dans les outils de lithographie électronique du commerce, sans modification autre que logicielle. Il peut cependant être également avantageux d'optimiser l'architecture de calcul de manière adaptée à la méthode de déconvolution choisie. Une architecture de calcul adaptée sera préférentiellement de nature hétérogène, c'est à dire contenant des processeurs standards et des unités de calculs particulières, par exemple des GPUs (Graphics Processing Unit, puces initialement dédiées au graphisme, mais qui ont aujourd'hui évolué pour développer une puissance de calcul vectoriel inédite) ou des FPGA (puces dont le circuit logique est programmable : il est donc possible de programmer une puce à l'efficacité optimisée pour un algorithme donné).

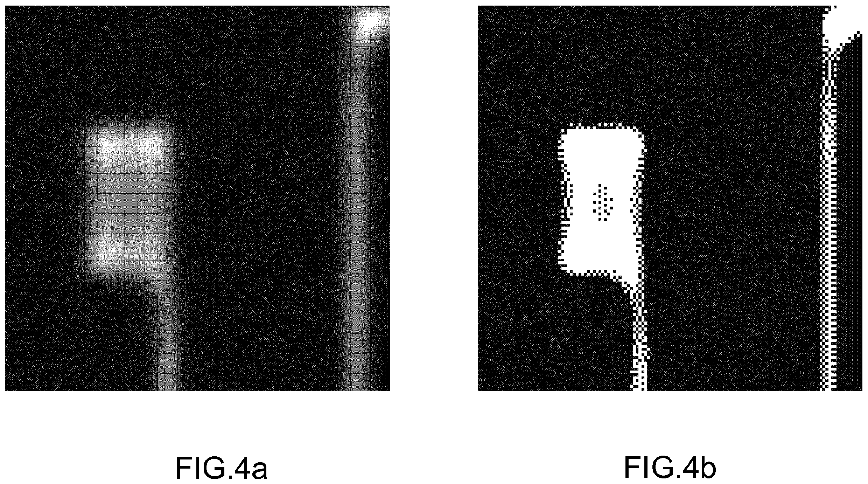

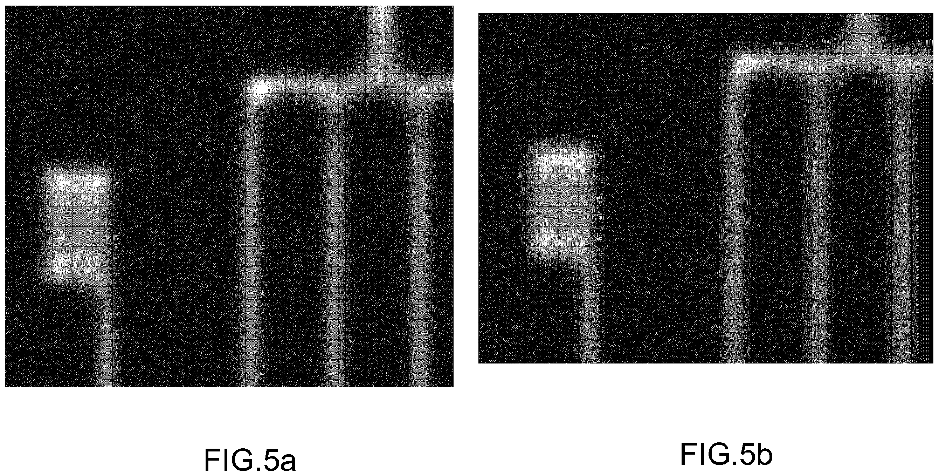

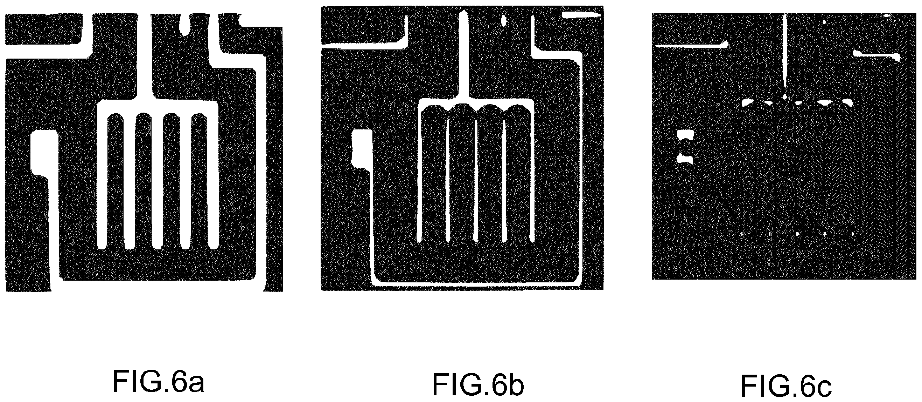

Il est ensuite nécessaire de convertir cette image en niveaux de gris en format exploitable par le type d'outil d'exposition utilisé (étapes 230a et 230b de la figure 2). Deux types principaux d'outil sont généralement utilisés, des outils à matrice de points, comme celui commercialisé par la société Mapper et des outils à formation de faisceau, comme ceux commercialisé par la société Vistec (Vistec SB250 electron beam lithography system par exemple) Dans le premier cas, la conversion est une opération de tramage. Dans le deuxième cas, il s'agit d'une opération de vectorisation. Ces deux étapes seront décrites en commentaires respectivement aux figures 4a, 4b et 5a, 5b. Dans le cas de la formation de faisceaux, il est avantageux, pour des motifs à exposer complexes, d'interposer une opération 240 de découpage en niveaux permettant l'exposition d'eRIF. Cette opération est décrite en commentaire aux figures 6a, 6b, 6c. Le motif à exposer est ensuite fracturé en zones correspondants chacune à un faisceau (étape 250).

Dans les deux procédés correspondant à l'outil à matrice de points et à l'outil à formation de faisceau, l'étape 260 d'exposition peut être alors déclenchée.

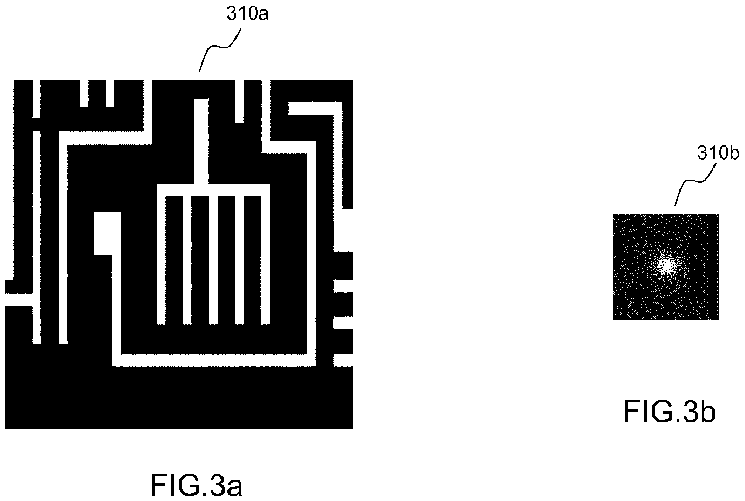

Les figures 3a et 3b représentent respectivement un motif à exposer et sa PSF associée, selon un mode de réalisation de l'invention.

La figure 3a représente un motif à exposer 310a. Ledit motif comprend des structures complexes, ayant chacune des dimensions critiques de l'ordre de la dizaine de nanomètres.

La figure 3b représente la PSF choisie 310b. Comme indiqué, dans le cadre de l'invention, on choisit avantageusement une PSF constituée par une fonction gaussienne modélisant l'effet de diffusion vers l'avant, qui domine aux dimensions d'intérêt pour les structures des types de motifs considérés.

Les figures 4a et 4b représentent respectivement une image en niveaux de gris d'un motif à exposer et sa transformée en image binaire par tramage, selon un mode de réalisation de l'invention.

Un outil de type Mapper accepte en entrée une image binaire (pixel 0 ou 1) : le passage d'image en niveaux de gris à image binaire s'appelle le tramage (*dithering*). Il existe de nombreux algorithmes pour effectuer cette transformation, le plus connu étant Floyd-Steinberg. C'est un algorithme à diffusion d'erreur. Cet algorithme effectue un tramage par la diffusion de l'erreur de quantification d'un pixel à ses voisins. Par exemple, un premier pourcentage de son erreur choisi en fonction du nombre de pixels est ajouté au pixel à sa droite, un deuxième pourcentage au pixel situé en bas à gauche, un troisième pourcentage au pixel situé en dessous et le complément au pixel en bas à droite. Les pourcentages sont choisis notamment en fonction du nombre de pixels.

Les figures 5a et 5b représentent respectivement une image en mode bitmap d'un motif à exposer et sa transformée en image vectorielle, selon un mode de réalisation de l'invention.

La vectorisation est une transformation de l'image comme ensemble de points (bitmap) en image dite vectorielle, qui représente des formes géométriques. Des zones sont alors délimitées correspondant à des doses différentes. Les niveaux de gris de la figure 5a sont restreints et leur étendue est transformée en polygones. Plusieurs algorithmes de vectorisation sont utilisables, par exemple Potrace (http://potrace.sourceforge.net/, http://potrace.sourceforge.net/potrace.pdf).

Les figures 6a, 6b et 6c représentent trois niveaux d'exposition différents, selon un mode de réalisation de l'invention.

Il est souvent avantageux de réaliser plusieurs passes d'exposition. Ce découpage en niveaux permet de réaliser un moins grand nombre de shots et autorise en conséquence une vitesse d'écriture plus rapide.

Pour décider du découpage en niveaux, on peut par exemple avantageusement réaliser un histogramme des valeurs prises par les pixels : plus un niveau de luminosité est peuplé (ie plus le nombre de pixels correspondant à ce niveau est élevé), plus il est judicieux de retenir ce niveau comme niveau d'exposition distinct.

Chaque niveau extrait par l'étape ainsi décrite reçoit une dose donnée qui peut être exposée en une seule passe. Sur la figure 6b, les lignes fines sont des eRIF générés automatiquement grâce à l'invention contrairement à l'art antérieur.

Il est ensuite possible de réaliser l'étape de fracturation consistant à découper les images vectorielles en formes élémentaires (triangles rectangles et rectangles) de taille adaptée au procédé qui seront exposées par l'outil VSB. Ce procédé de fracturation est bien connu de l'homme du métier de la lithographie électronique.

Avantageusement, une aide spécifique à la conception peut être intégrée dans les outils dont dispose l'opérateur.

La correction géométrique suppose une action de l'opérateur qui, en fonction de son savoir faire et des résultats des expositions déjà faites a idée des modifications automatiques (raccourcissement/élongation de lignes, etc.) qui doivent êtres appliquées à tout ou partie du circuit.

Pour aider cet opérateur lorsque les modifications ne sont pas triviales et qu'une intervention manuelle reste nécessaire, un outil mettant en oeuvre le procédé décrit peut être mis en oeuvre dans son application de design: une fenêtre, ouverte à sa demande, affiche une solution optimale. L'opérateur peut alors choisir de généraliser à des motifs ayant les mêmes caractéristiques les règles de correction qu'il observe dans cette fenêtre, créant ainsi une bibliothèque de règles de correction réutilisables pour des motifs similaires utilisant par exemple des algorithmes de reconnaissance automatique de forme.

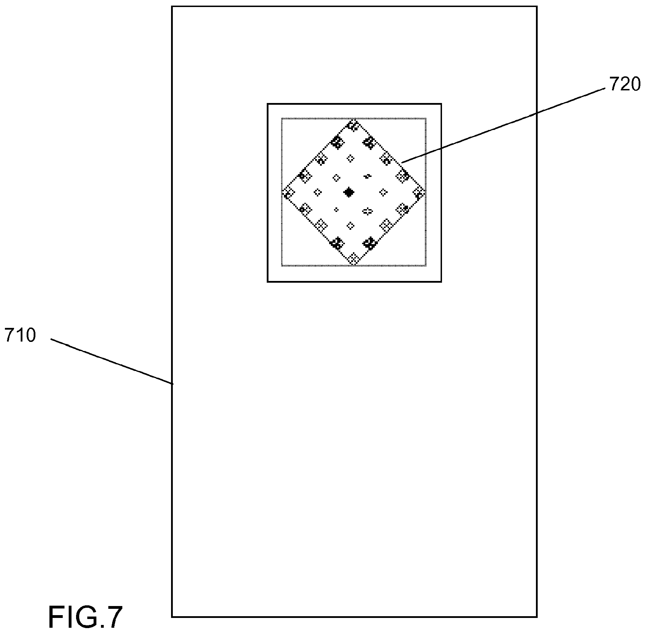

La figure 7 illustre un stencil comportant différentes ouvertures pour réaliser une ou plusieurs insolations dans un mode de réalisation utilisant une projection de cellule.

En lithographie électronique par projection standard, pour insoler une cellule du design, qui correspond à un ensemble de motifs à exposer, on utilise un stencil 710 qui est une plaque de métal dans laquelle sont formés des « trous ». Ces trous peuvent être considérés comme des caractères d'imprimerie. Chaque caractère est un ensemble de formes élémentaires (triangles, rectangles).Les caractères sont regroupés dans une cellule caractère 720 dont la géométrie correspond sensiblement à celle de la cellule de design à réaliser (des corrections géométriques sont néanmoins possibles). Plusieurs cellules caractères 720 peuvent être réalisées sur le même stencil pour réaliser différentes cellules de design. En règle générale, ces cellules caractères seront de géométries différentes.

Dans les modes de réalisation par projection de cellules multi-passes, on propose d'utiliser plusieurs cellules caractères correspondant chacune à un niveau d'exposition pour réaliser une cellule du design. Avantageusement, ces cellules caractères sont implantées sur le même stencil (ou « plaque caractère »), le changement de stencil étant une opération longue et méticuleuse dont on souhaite minimiser les occurrences.

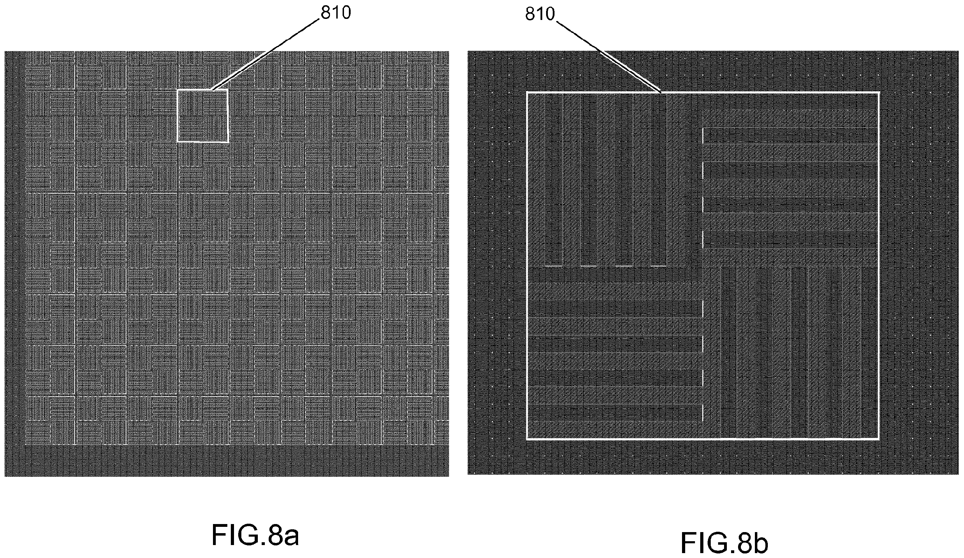

Les figures 8b et 8a représentent respectivement une cellule caractère d'un stencil de l'art antérieur et les cellules du design que l'on cherche à insoler par un procédé à projection de cellules correspondant à cette cellule caractère.

Le stencil de la figure 8b est utilisé pour insoler le design très répétitif de la figure 8a. Le motif unique 810 de la figure 8b remplace la centaine de shots qui aurait été nécessaire pour insoler le même motif en lithographie à faisceau formé. Le temps d'écriture en utilisant le stencil est donc divisé d'autant. La précision de l'insolation est cependant moins bonne, notamment parce que l'effet de diffusion vers l'arrière fait que les parties du dessin en bordure de la zone 810 reçoivent une dose moins élevée que les parties du dessin situées au centre de la zone.

Dans la technique de lithographie par projection de cellules standard, il n'est pas possible de réaliser une modulation de dose au sein de la cellule du design. La modulation de dose est effectuée d'une insolation à l'autre, soit d'une cellule du design à l'autre. C'est-à-dire qu'en pratique la cellule sera insolée plus ou moins longtemps selon qu'elle se situe en bord de zone exposée ou au coeur. Mais à chaque exposition, la cellule caractère laissera passer la même dose surfacique. La cellule caractère est déterminée après observation du design du circuit, de manière à factoriser une zone la plus grande possible. Une correction géométrique peut éventuellement intervenir au préalable.

Une méthode avantageuse permettant de réaliser conjointement une modulation de dose inter-cellules et une correction géométrique (adjonction de motifs au bord, à l'intérieur ou à l'extérieur, de manière jointive ou non) a été décrite dans la demande internationale n°PCT/EP2011/055861 déposée par un des titulaires de la présente demande. Dans le procédé divulgué par cette demande, avantageusement le dosage est uniforme pour toutes les cellules situées au centre du bloc à insoler, les cellules situées au bord du bloc recevant une dose supérieure calculée par une relation fonctionnelle faisant intervenir la latitude en énergie du procédé.

Cependant, l'effet de diffusion vers l'avant, qui domine à courte distance et affecte la précision de reproduction des motifs complexes qu'il pourrait être avantageux de traiter par projection de cellules, ne peut être corrigé facilement par ces techniques antérieures.

La cellule du design 810 est découpée par exemple en deux niveaux. Pour décider du découpage en niveaux, on peut par exemple avantageusement réaliser un histogramme des valeurs prises par les pixels : plus un niveau de luminosité est peuplé (ie plus le nombre de pixels correspondant à ce niveau est élevé), plus il est judicieux de retenir ce niveau comme niveau d'exposition distinct. Chaque niveau extrait par l'étape ainsi décrite reçoit une dose donnée qui peut être exposée en une seule passe.

Le calcul de la dose propre à chaque niveau peut être effectué par une extension de la modulation de dose pour une image à exposer à un seul niveau, le nombre N de niveaux constituant le nombre de paramètres du calcul. Pour chaque niveau d'exposition, on utilise une cellule caractère différente (avec des ouvertures différentes) et on applique au travers de chaque cellule caractère une dose spécifique.

On réalise la correction des effets de proximité intra-cellule en appliquant à la fois une modulation de dose et des corrections géométriques selon le procédé exposé plus haut.

L'image unique en niveaux de gris en sortie de la déconvolution est ensuite analysée pour être le cas échéant découpée en cellules caractères destinées à être exposés en plusieurs niveaux.

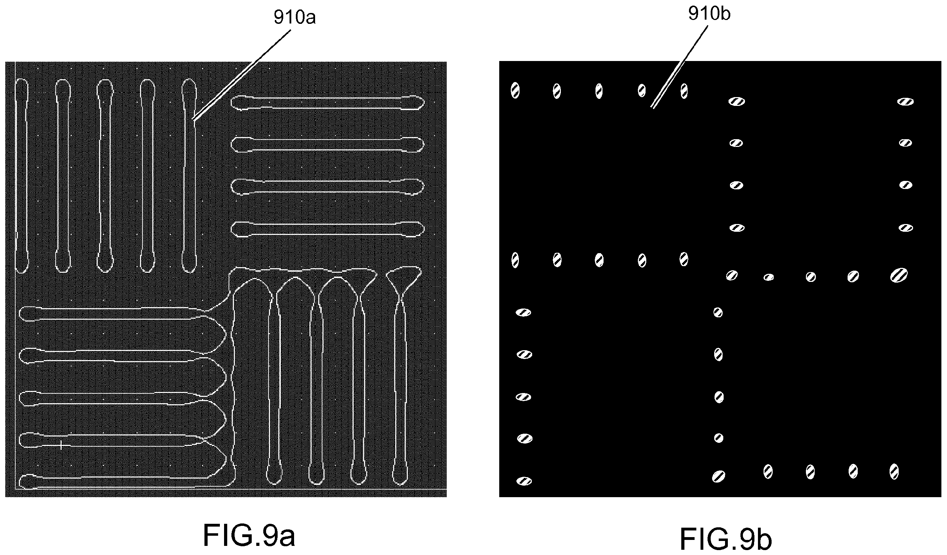

Les figures 9a et 9b représentent respectivement les deux cellules caractères déterminées pour exposer le motif source de la figure 8b.

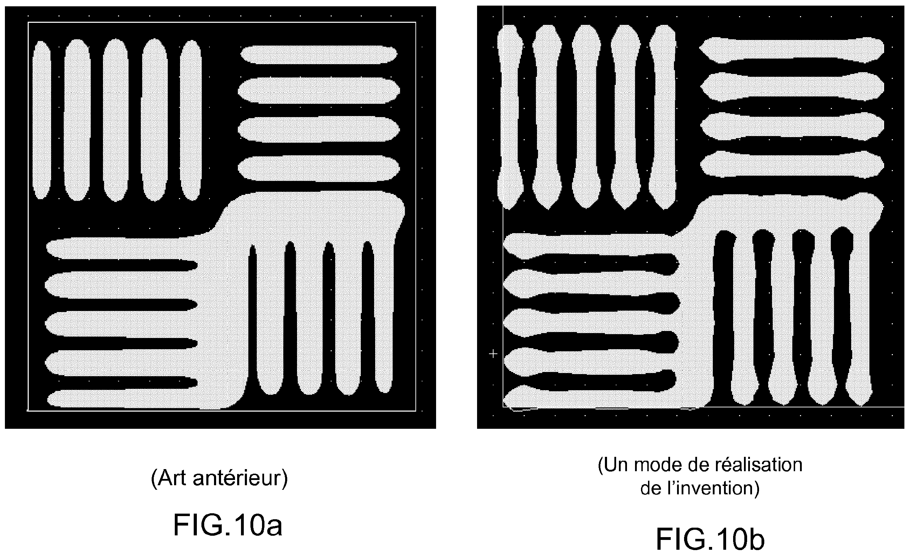

A titre d'exemple du procédé de découpage en niveaux, pour exposer le motif de la figure 8b, le dessin principal 910a de la figure 9a est exposé sur un 1$^{er}$ niveau avec une 1$^{ere}$ dose. Sur la figure 9b, des éléments 910b sont exposés sur un 2$^{eme}$ niveau avec une 2$^{eme}$ dose. Ces motifs sont traités comme le sont des eRIF dans un procédé standard. Ainsi, le motif de base est reconstitué par la superposition des deux niveaux exposés séparément. Dans l'exemple illustré par les figures 9a et 9b, la dimension caractéristique des lignes et des espaces de la figure 10a est de 32 nm.

Avantageusement, le motif de la figure 8b est d'abord déconvolué par une méthode du type de celles expliquées ci-dessus en commentaire aux figures 8a et 8b.

Les figures 10a et 10b représentent respectivement la cellule du design obtenue après insolation au travers de la cellule caractère de la figure 8b et celle obtenue après insolation au travers des deux cellules caractères des figures 9a et 9b.

On observe, en comparant les deux figures que, sur la figure 10a qui représente un cas de l'art antérieur, ni les largeurs de lignes, ni les fins de lignes ne sont maîtrisées. Sur la figure 10b qui représente un mode de réalisation à deux niveaux d'exposition, les largeurs et les fins de lignes sont conformes au design à reproduire.

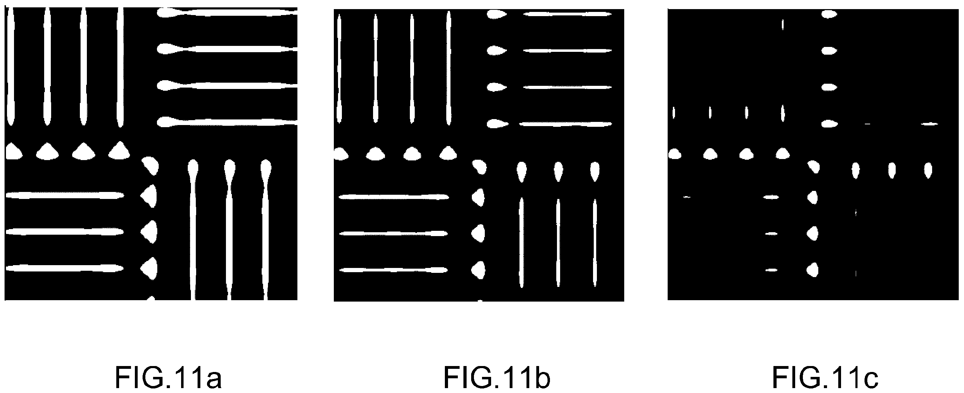

Les figures 11a, 11b et 11c représentent respectivement trois niveaux d'exposition différents réalisés avec trois cellules caractères.

On peut découper le motif de la figure 8b en plus de deux cellules caractères, correspondant chacun à un niveau différent d'exposition. Dans ce cas, des motifs intermédiaires sont créés.

Les trois figures 11a, 11b et 11c représentent une sélection de trois niveaux d'exposition parmi dix, lesdits niveaux étant déterminés par application d'une méthode de choix basée sur l'examen des niveaux de luminosité correspondant à un maximum de pixels.

Ces modes de réalisation peuvent être mis en oeuvre avec une machine et des stencils de l'art antérieur, par exemple une machine Vistec SB3050 Series avec l'option « cell projection ». Les seules modifications à apporter pour ces mises en oeuvre consistent en des modifications de nature logicielle permettant de réaliser le découpage des blocs à insoler en sous-ensembles destinés à être exposés en niveaux distincts. Si une déconvolution selon un des modes avantageux exposés dans la présente description est mise en oeuvre, ces modifications seront complétées par un ou des modules complémentaires prévus à cet effet.

Les exemples décrits ci-dessus sont donnés à titre d'illustration. Ils ne limitent en aucune manière le champ de l'invention qui est défini par les revendications qui suivent.

**Revendications**

1. Procédé de lithographie par rayonnement d'au moins un motif à insoler (310a) sur un support résiné comprenant au moins une étape de génération d'une fonction choisie d'étalement de point (310b) dudit rayonnement et une étape d'application (220) d'une méthode choisie de déconvolution audit motif à insoler par ladite fonction d'étalement de point, ledit procédé étant **caractérisé en ce que** ladite fonction d'étalement de point est choisie pour ne modéliser que les effets de diffusion dudit rayonnement vers l'avant et **en ce que** ladite méthode de déconvolution est choisie parmi les méthodes modélisant les interactions dudit rayonnement avec le support résiné par une distribution de probabilité conjointe des dites interactions.

2. Procédé de lithographie selon la revendication 1, **caractérisé en ce que** ladite méthode de déconvolution comprend une étape de calcul d'un maximum de vraisemblance de chaque point source dudit rayonnement pour tous les points image du motif à insoler, chaque point image étant multiplié par la valeur de la fonction d'étalement de point entre le point source et le point image.

3. Procédé de lithographie selon la revendication 2, **caractérisé en ce que** ladite méthode de déconvolution est une méthode de Lucy-Richardson.

4. Procédé de lithographie selon l'une des revendications 1 à 3, **caractérisé en ce que** qu'il comprend en outre une étape de tramage de l'image déconvoluée du motif à insoler.

5. Procédé de lithographie selon l'une des revendications 1 à 3, **caractérisé en ce qu'**il comprend en outre une étape de découpage de l'image déconvoluée en au moins deux niveaux distincts d'exposition.

6. Procédé de lithographie selon la revendication 5, **caractérisé en ce que** les au moins deux niveaux distincts d'exposition sont choisis pour maximiser la population en pixels de chacun des niveaux.

7. Procédé de lithographie selon l'une des revendications 5 à 6, **caractérisé en ce qu'**il comprend en outre une étape de vectorisation de l'image déconvoluée du motif à insoler.

8. Procédé de lithographie selon l'une des revendications 1 à 7, **caractérisé en ce que** la fonction d'étalement de point est une gaussienne.

9. Procédé de lithographie selon la revendication 8, **caractérisé en ce que** la largeur à mi-hauteur de la gaussienne est comprise entre 3nm et 15nm.

10. Programme d'ordinateur comprenant des instructions de code de programme mettant en oeuvre, lorsque le programme est exécuté sur un ordinateur, le procédé de lithographie par rayonnement selon l'une des revendications 1 à 9, ledit programme comprenant une fonction de génération d'une fonction choisie d'étalement de point dudit rayonnement et un module d'application d'une méthode choisie de déconvolution aux sorties éventuellement filtrées de ladite fonction d'étalement des points dudit rayonnement appliquée audit motif à insoler, ledit programme étant **caractérisé en ce que** ladite fonction d'étalement de point est choisie pour ne modéliser que les effets de diffusion dudit rayonnement vers l'avant et **en ce que** ladite méthode de déconvolution est choisie parmi les méthodes modélisant les interactions des points dudit rayonnement par une distribution de probabilité conjointe des dites interactions.

11. Programme d'ordinateur selon la revendication 10, **caractérisé en ce qu'**il comprend en outre une fenêtre d'interface dans laquelle un opérateur peut programmer l'application à au moins un deuxième motif appartenant à une classe déterminée de règles de correction déterminées par déconvolution d'un premier motif appartenant à ladite classe.

**Patentansprüche**

1. Lithographieverfahren durch Bestrahlen von wenigstens einem zu belichtenden Muster (310a) auf einem verharzten Substrat, das wenigstens einen Schritt des Erzeugens einer gewählten Punktstreufunktion (310b) der Strahlung und einen Schritt (220) des Anwendens eines gewählten Entfaltungsverfahrens auf das durch die Punktstreufunktion zu belichtende Muster beinhaltet, wobei das Lithographieverfahren **dadurch gekennzeichnet ist, dass** die Punktstreufunktion so gewählt ist, dass nur die Vorwärtsstreueffekte der Strahlung modelliert werden, und dadurch, dass das Entfaltungsverfahren aus den Verfahren des Modellierens der Interaktionen der Strahlung mit dem verharzten Substrat durch eine gemeinsame Probabilitätsverteilung der Interak-

**2.** Lithographieverfahren nach Anspruch 1, **dadurch gekennzeichnet, dass** das Entfaltungsverfahren einen Schritt des Berechnens einer maximalen Wahrscheinlichkeit jedes Quellpunkts der Strahlung für alle Bildpunkte des zu belichtenden Musters beinhaltet, wobei jeder Bildpunkt mit dem Wert der Punktstreufunktion zwischen dem Quellpunkt und dem Bildpunkt multipliziert wird.

**3.** Lithographieverfahren nach Anspruch 2, **dadurch gekennzeichnet, dass** das Entfaltungsverfahren ein Lucy-Richardson-Verfahren ist.

**4.** Lithographieverfahren nach einem der Ansprüche 1 bis 3, **dadurch gekennzeichnet, dass** es ferner den Schritt des Rasterns des entfalteten Bildes des zu belichtenden Musters beinhaltet.

**5.** Lithographieverfahren nach einem der Ansprüche 1 bis 3, **dadurch gekennzeichnet, dass** es ferner einen Schritt des Unterteilens des gefalteten Bildes in wenigstens zwei separate Belichtungsniveaus beinhaltet.

**6.** Lithographieverfahren nach Anspruch 5, **dadurch gekennzeichnet, dass** die wenigstens zwei Belichtungsniveaus so gewählt werden, dass die Pixelpopulation jedes der Niveaus maximiert wird.

**7.** Lithographieverfahren nach einem der Ansprüche 5 bis 6, **dadurch gekennzeichnet, dass** es ferner einen Schritt des Vektorisierens des entfalteten Bildes des zu belichtenden Musters beinhaltet.

**8.** Lithographieverfahren nach einem der Ansprüche 1 bis 7, **dadurch gekennzeichnet, dass** die Punktstreufunktion eine Gaußsche Funktion ist.

**9.** Lithographieverfahren nach Anspruch 8, **dadurch gekennzeichnet, dass** die Breite in halber Höhe der Gaußschen Funktion zwischen 3 nm und 15 nm liegt.

**10.** Computerprogramm, das Programmcode-Befehle umfasst, die bei Ausführung des Programms auf einem Computer das Lithographieverfahren durch Bestrahlung nach einem der Ansprüche 1 bis 9 implementieren, wobei das Programm eine Funktion des Erzeugens einer gewählten Punktstreufunktion der Strahlung und ein Modul zum Anwenden eines gewählten Entfaltungsverfahrens auf die eventuell gefilterten Ausgänge der Punktstreufunktion der auf das zu belichtende Muster angewandten Strahlung umfasst, wobei das Programm **dadurch gekennzeichnet ist, dass** die Punktstreufunktion so gewählt ist, dass nur die Vorwärtsstreueffekte der Strahlung modelliert werden, und dadurch, dass das Entfaltungsverfahren aus den Verfahren ausgewählt ist, die die Interaktionen der Punkte der Strahlung durch eine gemeinsame Probabilitätsverteilung der Interaktionen modellieren.

**11.** Computerprogramm nach Anspruch 10, **dadurch gekennzeichnet, dass** es ferner ein Schnittstellenfenster umfasst, in dem ein Bediener die Anwendung auf wenigstens ein zweites Muster programmieren kann, das zu einer bestimmten Klasse von Korrekturregeln gehört, die durch Entfalten eines zu dieser Klasse gehörenden ersten Musters bestimmt werden.

**Claims**

**1.** A method of lithography by applying a radiation to at least a pattern (310a) to be exposed on a resinated support, comprising at least a step of generating a selected point spread function (310b) of said radiation and a step (220) of applying a selected deconvolution method to said pattern to be exposed by said point spread function, said lithography method being **characterised in that** said point spread function is selected so as to model only the effects of forward scattering of said radiation and **in that** said deconvolution method is selected from the methods modelling the interactions of said radiation with said resinated support by a joint probability distribution of said interactions.

**2.** The lithography method according to claim 1, **characterised in that** said deconvolution method comprises a step of computing a maximum likelihood of each source point of said radiation for all of the image points of the pattern to be exposed, each image point being multiplied by the value of the point spread function between the source point and the image point.

**3.** The lithography method according to claim 2, **characterised in that** said deconvolution method is a Lucy-Richardson method.

**4.** The lithography method according to any one of claims 1 to 3, **characterised in that** it further comprises a step of weaving the deconvoluted image of the pattern to be exposed.

**5.** The lithography method according to any one of claims 1 to 3, **characterised in that** it further comprises a step of cutting the deconvoluted image into at least two distinct exposure levels.

**6.** The lithography method according to claim 5, **characterised in that** said at least two distinct exposure levels are selected in order to maximise the pixel population of each of said levels.

**7.** The lithography method according to any one of claims 5 to 6, **characterised in that** it further comprises a step of vectorising the deconvoluted image of the pattern to be exposed.

**8.** The lithography method according to any one of claims 1 to 7, **characterised in that** the point spread function is a Gaussian function.

**9.** The lithography method according to claim 8, **characterised in that** the mid-height width of the Gaussian function is between 3 nm and 15 nm.

**10.** A computer program comprising program code instructions implementing, when said program is executed on a computer, the method of lithography by applying radiation according to any one of claims 1 to 9, said program comprising a function for generating a selected point spread function of said radiation and a module for applying a selected deconvolution method to the possibly filtered outputs of said point spread function of said radiation applied to said pattern to be exposed, said program being **characterised in that** said point spread function is selected so as to only model the effects of forward scattering said radiation and **in that** said deconvolution method is selected from the methods modelling the interactions of the points of said radiation using a joint probability distribution of said interactions.

**11.** The computer program according to claim 10, **characterised in that** it further comprises an interface window, in which an operator can program the application to at least a second pattern belonging to a predetermined category of correction rules determined by deconvoluting a first pattern belonging to said category.

FIG.1

```
┌─────────────────────────────────────────┐
│  Détermination du type  de PSF          │        210
│  et calcul des paramètres de la PSF optimale │
└─────────────────────────────────────────┘

┌─────────────────────────────────────────┐
│  Calcul des points de l'image source par déconvolution │   220
│  de l'image destination par une méthode probabiliste   │
└─────────────────────────────────────────┘
```

Outils à matrice de points

Outils à formation
de faisceau

Découpage en niveaux     240b

Tramage     230a

Vectorisation     230b

Fracturation     250a

Exposition     260

FIG.2

310a

FIG.3a

310b

FIG.3b

EP 2 756 518 B1

FIG.4a

FIG.4b

FIG.5b

FIG.5a

FIG.6a

FIG.6b

FIG.6c

EP 2 756 518 B1

FIG.7

810

FIG.8b

810

FIG.8a

FIG.9b

FIG.9a

(Art antérieur)

FIG.10a

(Un mode de réalisation
de l'invention)

FIG.10b

FIG.11c

FIG.11b

FIG.11a

**EP 2 756 518 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2011055746 W
- EP 2011055863 W
- EP 2011055861 W

**Littérature non-brevet citée dans la description**

- **H. EISENMANN ; T. WAAS ; H. HARTMANN.** Proxecco - Proximity Effect Correction by Convolution. *J. Vac. Sci. Technol.,* Novembre 1993, vol. B11 (6), 2741-2745
- **H. SEWELL.** Control of Pattern Dimensions in Electron Lithography. *J. Vac. Sci. Technol.,* 1978, vol. 15, 927
- **BRIAN D. COOK ; SOO YOUNG LEE.** Dose, Shape and Hybrid Modifications for PYRAMID in Electron Beam Proximity Effect Correction. *IEEE transactions on semiconductor manufacturing,* Février 1998, vol. 11 (1
- **L. MARTIN.** New writing strategy in electron beam direct write lithography to improve critical dense fines patterning for sub-45nm nodes. *EMLC,* 2009
- Transform based proximity corrections : Expérimental results and comparisons. **M.E. HASLAM, J.F. ; MCDONALD.** J. Vac. Sci. Technol. Center for Integrated Electronics, Rensselaer Polytechnic Institute, Janvier 1986, vol. B4
- Bayesian-Based Iterative Method of Image Restoration. **W. HADLEY-RICHARDSON.** Journal of the Optical Society of America. Visibility Laboratory, University of California at San Diego, Janvier 1972, vol. 62